# EUROPEAN PATENT APPLICATION

(11) **EP 1 501 116 A2**
(43) Date of publication of application: **26.01.2005**
(21) Application number: 04017465.8
(22) Date of filing: 23.07.2004
(51) Int. Cl.: H01L 21/00

(54) **Electrostatic chuck having electrode with rounded edge**

(30) Priority: 23.07.2003 US 626156
(71) Applicant: Applied Materials, Inc., Santa Clara, California 95054 (US)
(72) Inventor: Ramaswamy, Kartik, Santa Clara, CA 95051 (US); McChesney, Jon M., Santa Clara, CA 95051 (US); Kumar, Ananda H., Fremont CA 95035 (US); Noorbakhsh, Hamid, Fremont CA 94539 (US)
(74) Representative: Zimmermann, Gerd Heinrich

(57) **Abstract**

An electrostatic chuck provides reduced electric field effects about its peripheral edge. The chuck comprises a dielectric covering an electrode having a central planar portion with top and bottom surfaces. In one version, the electrode also has a wire loop extending about its perimeter, the wire loop having a radially outwardly facing surface that is substantially rounded. Altematively, the electrode has a peripheral arcuate portion having a tip with a curvature length of at least about π/8 radians between a normal to the top surface of the central planar portion and a normal to the upper surface of the tip. A dielectric covers the electrode. The electrostatic chuck is used to hold a substrate in a process chamber of a substrate processing apparatus.

## Description

### BACKGROUND

The present invention relates to an electrostatic chuck that may be used to hold a substrate in a substrate processing chamber.

In the fabrication of electronic circuits and displays, semiconductor, dielectric, or conductor materials are formed on a substrate, such as a silicon wafer or glass. The materials are typically formed by chemical vapor deposition (CVD), physical vapor deposition (PVD), oxidation and nitridation processes. Thereafter, the materials are etched to form features such as gates, vias, contact holes and interconnect lines. In a typical etching process, a patterned mask of photoresist or oxide hard mask is formed on the substrate by photolithography, the substrate is placed in a process chamber and a plasma is formed in the chamber to etch exposed portions of the substrate.

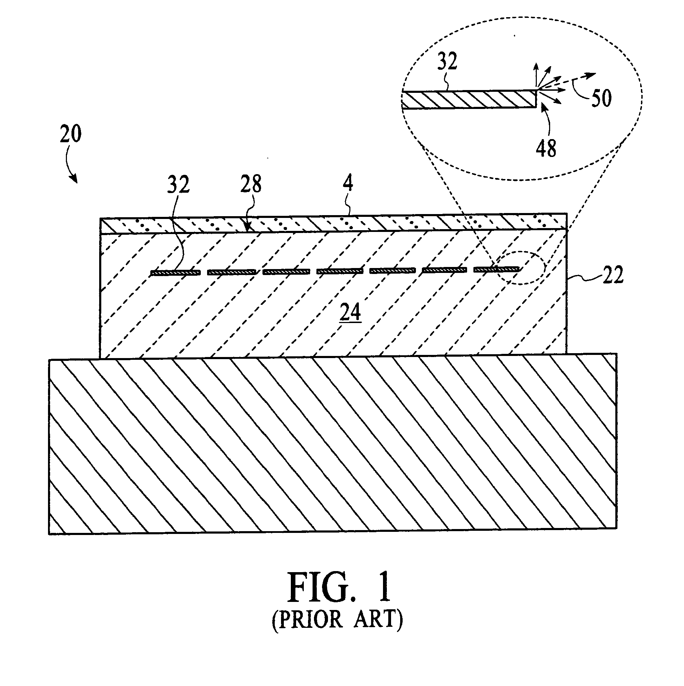

The process chamber has an electrostatic chuck **20** to hold the substrate in the chamber as illustrated in Figure 1 (Prior Art). The electrostatic chuck **20** comprises a dielectric **24** covering an electrode **32** and having a receiving surface **28** on which to receive the substrate **4**. The entire electrode **32** lies in the same horizontal plane. Typically, a DC electric potential is applied to the electrode **32** to apply an electrostatic force to the substrate **4** that clamps the substrate **4** to the receiving surface **28**. A high voltage RF potential can also be applied to the electrode **32** to energize a process gas in the chamber to form a plasma to process the substrate **4**.

However, one problem with such conventional chucks **20** arises when the high voltages or potentials applied to the electrode **32** of the chuck **20** leaks out as current leakage shown by the electric field vector **50** from the edges **48** of the electrode **32** through the sidewall edge **22** of the surrounding dielectric **24** and into the plasma. The current leakage **50** can weaken the clamping force applied on the substrate **4**, causing the substrate **4** to be weakly held on the receiving surface **28** of the electrostatic chuck **20**. Poor chucking force can cause the substrate 4 to shift position on the surface **28** or even be dislodged from the surface **28.** An improperly positioned substrate **4** is exposed to a non-uniform plasma resulting in uneven processing across the surface of the substrate **4.** In addition, the current leakage **50** can form an unstable plasma at the electrode edge **48** that can exacerbate the non-uniform processing of the substrate **4**. The leakage problem is worsened when a chamber sidewall (not shown) opposing the dielectric sidewall edge **22** and facing the electrode edge **48**, is grounded or maintained at a floating potential because the current from the electrode edge **48** has a short pathway through the dielectric sidewall edge 22 to reach the chamber sidewall.

Thus, it is desirable to have an electrostatic chuck that can securely hold a substrate. It is further desirable to have an electrostatic chuck with reduced current leakage from the electrode and through the sidewall edge of the chuck. It is also desirable to have an electrostatic chuck that is able to generate uniform electric fields across from the center to the edge of the electrode.

### Summary of the invention

The above mentioned and related problems are solved by the electrostatic chuck according to claim 1 and the substrate processing apparatus according to claim 8.

Further details, preferred embodiments and improvements of the invention are disclosed in the dependent claims, the figures and the description.

The electrostatic chuck according to claim 1 is capable of providing reduced electric field effects about its peripheral edge. The chuck comprises a dielectric covering an electrode having a central planar portion with top and bottom surfaces. In one version, the electrode also has a wire loop extending about its perimeter, the wire loop having a radially outwardly facing surface that is substantially rounded. In another version, the electrode has a peripheral arcuate portion having a tip with a curvature length of at least about π/8 radians between a normal to the top surface of the central planar portion and a normal to the upper surface of the tip. A dielectric covers the electrode. The electrostatic chuck is used to hold a substrate in a process chamber of a substrate processing apparatus.

### DRAWINGS

These features, aspects, and advantages of the present invention will become better understood with regard to the following description, appended claims, and accompanying drawings which illustrate versions of the invention, where:
Figure 1 (Prior Art) is a cross-sectional side view of an embodiment of a conventional electrostatic chuck having a planar electrode;
Figure 2 is a cross-sectional side view of an embodiment of an electrostatic chuck having an electrode with a wire loop having a radially outwardly facing surface that is substantially rounded, and that extends substantially continuously about the perimeter of the electrode;
Figure 3 is a cross-sectional side view of an embodiment of an electrostatic chuck having an electrode with a peripheral arcuate portion; and
Figure 4 is a schematic side view of an embodiment of a process chamber comprising the electrostatic chuck of Figure 2.

### DESCRIPTION

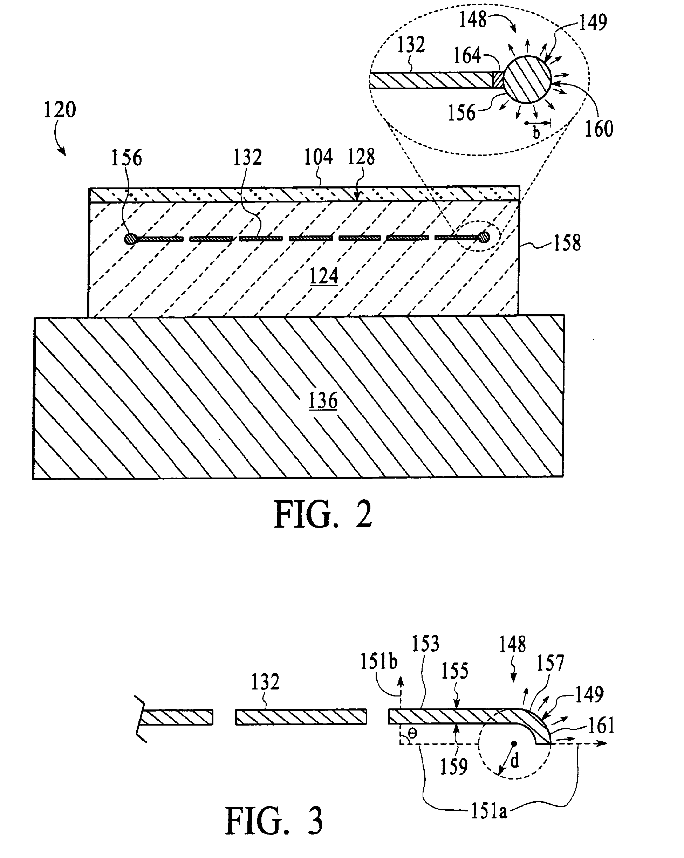

An electrostatic chuck **120** holds a substrate **104** in a process zone **112** during processing, as illustrated in the exemplary embodiment of Figure 2. The electrostatic chuck **120** comprises a dielectric **124** with a receiving surface **128** on which to receive the substrate **104**. The dielectric **124** typically comprises a ceramic, such as aluminum nitride or aluminum oxide. The dielectric ceramic can be doped with a dopant, such as titanium oxide in aluminum oxide, to make the material more semi-conductive to allow easier removal of accumulated surface charge. The electrostatic chuck **120** further comprises an electrode **132** that is covered by the dielectric **124.** The dielectric **124** can cover the top surface of the electrode **132** in a continuous layer, or the electrode **132** may be embedded in the dielectric **124** so that the dielectric surrounds and encompasses the electrode.

The chuck electrode **132** typically is composed of a conductor, such as a metal, for example, copper, aluminum or molybdenum. Typically, the electrode **132** is shaped and sized to correspond to the shape and size of the substrate **104,** for example, if the substrate **104** is a disk-shaped wafer, a disk-shaped electrode having a round or square cross-section can be used. The electrode 132 can be monopolar with a single segment that is maintained at one potential, or bipolar with two or more segments that are maintained at different potentials or polarities. In one version, the electrode **132** comprises a wire mesh - such as a grid of round wire, which is easier to embed into a dielectric **124.** However, the electrode **132** can also be a metal plate hole stamped with apertures, or a continuous layer such as a sheet of metal.

The electrode **132** in the electrostatic chuck **120** has an edge **148** that is substantially rounded about a plane orthogonal to the plane of the receiving surface **128** of the electrostatic chuck **120,** as for example illustrated in the embodiments shown in Figures 2 and 3, to reduce current leakage from the electrode **132**. The edge **148** is a rounded portion of the electrode **132** that is generally orthogonal to the receiving surface **128** of the electrostatic chuck **120**. The electrostatic chuck **120** has a lower electric field strength at the edge **148**, where the electric field strength is the change in electric potential across a unit distance. The electric field vectors are shown as arrows in Figures 2 and 3, pointing in the direction of the electric field at points near the radially outwardly facing surface **149** of the edge **148** of the electrode **132**, while the lengths of the vectors indicate the magnitude of the electric field at those points. The rounded edge **148** reduces the electric potential per unit area across the sidewall edge **158** of the chuck **120** such that electrical breakdown through the sidewall edge **158** of the dielectric **124** is less likely. The rounded edge **148** of the electrode **132** is located near the perimeter of the chuck **120** to reduce electric field emanations from the radially outermost or peripheral portion of the chuck **120.**

In a first version, an exemplary embodiment of which is shown in Figure 2, the electrode **132** comprises a wire loop **156** that extends substantially continuously about the perimeter **160** of the electrode **132.** For example, while the substantially continuous wire loop **156** can have breaks, it should cover at least about 60% of the outer perimeter of the electrode **132** to reduce edge effects along most of the electrode perimeter. The rounded wire loop **156** reduces electric field emanations from any sharp edges or points along the perimeter of the electrode **132.** The wire loop **156** has a radially outwardly facing surface **149,** which is the surface distant from the center of the electrostatic chuck **120,** that is substantially rounded. The substantially rounded wire loop has at least one radius of curvature of its outer edge. The rounded cross-section has a finite length with a sufficiently high curvature diameter (d) to reduce, or even substantially prevent, current leakage from the electrode **132** and through the sidewall edge **158** of the electrostatic chuck **120.** For example, the wire loop **156** may have a cross-section that is substantially circular, and the cross-section of the wire loop can have a diameter that is larger than the cross-sectional thickness of the electrode. The wire loop **156** can be a circle, an ellipse, or a semi-ellipse. With the attached rounded wire loop **156,** the electric field near the radially outwardly facing surface **149** of the edge **148** is weakened such that current leakage through the sidewall edge **158** is less likely to occur. The electric charge in the perimeter **160** distributes across the radially outwardly facing surface **149** such that the electric field at the radially outwardly facing surface **149** is weakened. The rounded wire loop **156** may be attached to the perimeter **160** of the electrode **132** with a conductive bond **164**. For example, the wire loop **156** may be brazed onto the electrode **132** at the perimeter **160** using a brazing compound between the rounded wire loop **156** and the electrode **132**. Alternatively, the electrode **132** my be stamped or pressed out of a metal sheet to have a radially outwardly facing surface **149** that is substantially rounded.

At an edge **148,** a hypothetical circle can be drawn that defines the curvature at the edge **148**, such as the curvature of the wire loop **156**. The diameter of the circle is referred to as the curvature diameter (d). This hypothetical circle can hug the inside of a cross-section of the radially outwardly facing surface **149** along a substantially continuous and finite section of the circle's perimeter, as shown in Figure 2. The degree of curvature at the radially outwardly facing surface **149** of the edge **148** is indicated by the diameter of this circle. For example, a sharper edge **148** has a greater curvature and thus corresponds to a smaller curvature diameter, while a smoother edge **148** has a lesser curvature and thus corresponds to a greater curvature diameter. An exemplary electrode **132** with desirable electrical performance has a perimeter with an edge **148** having a curvature diameter (d) of at least about 3 micrometers, or even at least about 4 micrometers for substantially improved performance. For example, the wire loop can have a diameter of at least about 3 micrometers. The electric field strength at the surface is approximately inversely proportional to the curvature diameter (d) at the edge **148.**

In contrast to the first version described above, a conventional electrode **32,** as shown in Figure 1 (Prior Art), has an edge that lies in a horizontal plane and consequently generates an undesirably strong electric field at its sharp edge **48**. When an electric potential is applied to the conventional electrode **32**, electric charge accumulates at the edge **48**. Since the edge **48** is surrounded by electrically neutral space, electric charge gathers in the sharp edge **48** in a higher density than throughout the rest of the conventional electrode **32** to maintain a uniform potential throughout the conventional electrode **32**. The high density of electric charge in the conventional electrode **32** causes a strong electric field to emanate from the edge **48**, which can cause electrical breakdown in the adjacent dielectric material **24** and thereby also undesirable electrical discharge from the conventional electrode **32** through the sidewall **22** of the adjacent dielectric material **24**. The electrical discharge can weaken the electrostatic holding strength of the electrostatic chuck **20** such that the substrate **4** is not securely held or is even unintentionally released. The electric field from the edge **48** is even stronger when chamber sidewalls directly facing the edge **48** are maintained at a floating or ground potential for example, to form a secondary electrode to generate or sustain a plasma in the chamber.

In a second version, an exemplary embodiment of which is illustrated in Figure 3, the electrode **132** has a central planar portion **153** that makes up most of the area below the substrate receiving surface, and a peripheral arcuate portion **157** that is arcuate about a plane that is substantially orthogonal to the plane of the central portion **153.** The central portion **153** comprises a top surface **155** and a bottom surface **159** that are each planar and substantially parallel to one another. The peripheral arcuate portion **157** of the electrode **132** is bowed in a substantially continuous a single or multi-radius arc which ends in a tip **161.** For example, the arcuate portion **157** may be bowed through an angle (θ) that is sufficiently large to reduce, or even substantially prevent, current leakage from the edge **148** of the chuck **120.** The angle (θ) refers to the angle formed between (i) a normal vector **151a** to the upper radially outwardly facing surface **149** of the peripheral arcuate portion **157** and (ii) a normal vector **151 b** to the top surface **155** of the central planar portion **153.** In one embodiment, the electrode edge **148** is bowed through an angle (θ) of at least about Π/8 radians, substantially preventing current leakage by exposing the surrounding dielectric **124** to the smooth upper radially outwardly facing surface **149** of the peripheral arcuate portion **157**.

As with the wire loop version, the peripheral arcuate portion **157** can also has a curvature diameter (d) of at least about 3 micrometers. The electrode **132** may be bowed in a downward or upward direction, and even in an inward direction. Preferably, the tip **161** of the peripheral arcuate portion **157** extends substantially entirely beyond the bottom surface **159** of the central planar portion **153,** so that the electric field from the tip **161** is directed downward and not upward into the plasma. Bowing the electrode edge **148** exposes the side of the dielectric **124**, which is particularly prone to electrical breakdown, to the rounded, bowed upper radially outwardly facing surface **14**9 rather than to a sharp tip of the electrode **132**. When an electric potential is applied to the electrode 132, the electric field emerging from the peripheral arcuate portion **157** is weaker than the electric field would be from a sharp tip.

The electrostatic chuck **120** can also have a base **136** below the dielectric **124,** which may be made from, for example, a metal or a ceramic. The process chamber **108** can also include a chuck lift (not shown) to raise and lower the electrostatic chuck **120,** and thereby also the substrate **104,** into and out of the process zone **112.**

In one method of manufacturing the electrostatic chuck **120,** a mold is filled to a first level with ceramic powder. An electrode **132** is adapted to have a rounded edge **148**, as described above. For example, a wire loop **156** having an outer surface that is substantially rounded may be brazed or bonded to the perimeter **160** of the electrode **132,** or the edge **148** of the electrode **132** may be bowed to have a peripheral arcuate portion **157.** The wire loop **156** can be selected to have a radially outwardly facing portion with a sufficiently large curvature diameter (d) that is at least about 3 micrometers. For example, if the metal of the electrode **132** is sufficiently malleable, the electrode **132** can be shaped by selectively applying pressure at the edge **148** until an arcuate profile with a sufficiently large curvature diameter (d) to substantially prevent current leakage is obtained. Alternatively, the edge **148** of the electrode **132** may be rounded by mechanically abrading the edge **148** against a roughened surface. The electrode **132** is then placed on the ceramic powder at the first level. The mold is filled to a second level with more ceramic powder to cover the electrode **132**. For a ceramic powder comprising aluminum oxide, the mixture in the mold can be sintered at a temperature of from about 500 to about 2000 °C to form a ceramic monolith enclosing the electrode **132.**

The electrostatic chuck **120** described above is capable of holding a substrate **104** more securely. For example, an electrostatic chuck **120** having an electrode **132** according to the present invention can have a current leakage through the sidewall edge **158** of the dielectric **124** that is less than about 100 µA and more preferably less than **50** µA. Prior art chucks **20** often have a current leakage through the sidewall edge **22** of the dielectric **24** that is 300 µA or more. This three-fold reduction in the current leakage from the sidewall edge **158** allows the electrostatic chuck **120** to hold the substrate **104** reliably and with adequate force onto the receiving surface **128** during processing. The improved electrostatic chuck **120** can also prevent damage to the dielectric **124** surrounding the electrode **132** by reducing the likelihood of electrical discharges through the dielectric **124.** It should be noted that the current leakage is dependent upon the voltage applied to the chuck **120,** so the present current leakage values are for a voltage of -1500 to -2000 volts that is applied to the electrode **132** of the chuck **120.** Also, the current leakage through the top surface **155** of the electrode **132** is also typically much smaller than the current leakage through the sidewall edge **158** of the chuck **120**.

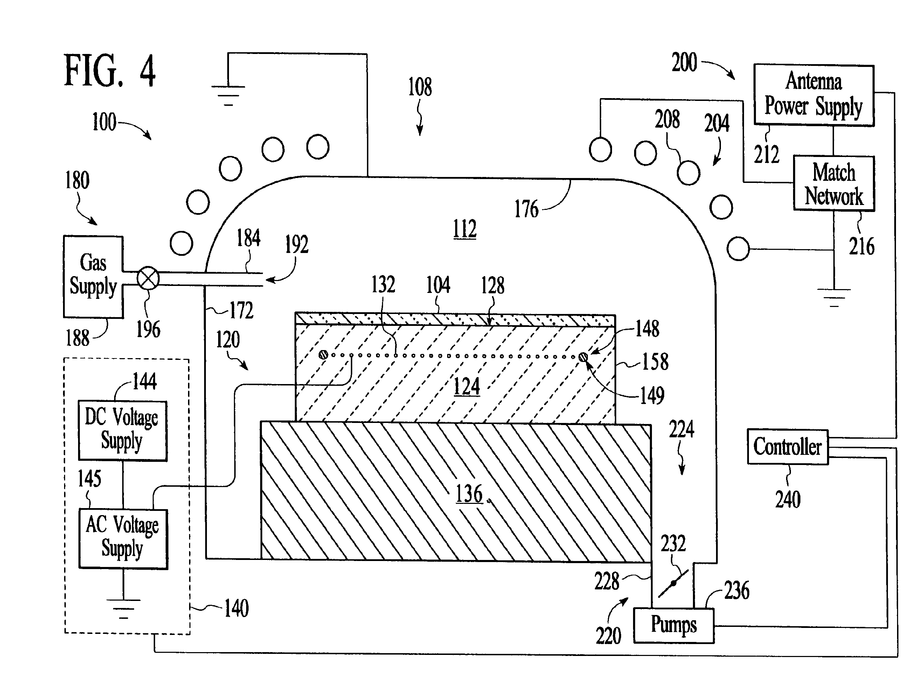

The electrostatic chuck **120** is used as part of a process chamber **108** in an apparatus **100** that is suitable for processing a substrate **104**, as illustrated in Figure 4. The process chamber **108** comprises walls **172,176** that enclose the process zone **112** in which the substrate **104** is processed. For example, the process chamber **108** may comprise sidewalls **172,** a bottom wall (not shown), and a ceiling **176** that faces the substrate **104.** The ceiling **176** may act as an anode and may be grounded (as shown) or electrically biased by a power supply (not shown). The chamber **108** comprises walls **172,176** fabricated from any of a variety of metal, ceramics, glasses, polymers, and composite materials. For example, metals commonly used to fabricate the chamber **108** include aluminum, anodized aluminum, "HAYNES 242," "Al-6061," "SS 304," "SS 316," and INCONEL. Anodized aluminum is typically preferred, and may have a surrounding liner (not shown). The ceiling **176** may comprise a flat, rectangular, arcuate, conical, dome or multiradius-arcuate shape.

The process chamber **108** may be an etch chamber, an embodiment of which is illustrated in Figure 4, to etch material from a substrate **104,** such as to etch a metal-containing material from the substrate **104.** The particular embodiment of the apparatus **100** shown in Figure 4 is suitable in the fabrication of electronic devices on a substrate **104,** and is provided only to illustrate the invention. This particular embodiment should not be used to limit the scope of the invention. The substrate **104** to be etched may comprise a silicon, compound semiconductor or glass substrate, comprising dielectric, semiconductor or conductor material. The process chamber **108** may also be adapted to process other substrates **104**, such as flat panel displays, polymer panels, or other electrical circuit receiving structures. The invention is especially useful for etching a metal-containing material on the substrate **104**, the metal-containing material comprising, for example, a stack of different metal-containing layers (not shown). A typical process sequence for forming the etched features comprises the steps of (1) sequentially depositing the layers on the substrate **104,** (2) forming an overlying mask layer that captures a pattern that is to be transferred into the metal-containing material, and is typically composed of photoresist, but can be made of other materials, such as silicon dioxide or silicon nitride, and (3) etching the substrate **104** to transfer the pattern captured in the mask into the metal-containing material, for example to form the etched features.

The electrostatic chuck **120** electrostatically holds the substrate **104** in the process chamber **108** and regulates the temperature of the substrate **104**. The electrostatic chuck **120** is connected to an electrode voltage supply **140** comprising an AC voltage supply **145** that applies an alternating voltage to the electrode **132** to sustain the plasma by affecting the ion energy of the plasma. A DC voltage supply **144** also biases the electrode **132** to create an electrostatic downward force on the substrate **104.** In one embodiment, the electrode voltage supply **140** applies an electric potential to the electrode **132** of from about -700 to about -3000 volts with respect to the plasma, or even from about -1500 to -2000 volts.

The substrate processing apparatus **100** further comprises a gas distributor **180** that introduces a process gas into the process chamber **108** to process the substrate **104**. The gas distributor **180** comprises a gas feed conduit **184** that can transport the process gas from a gas supply **188** to one or more gas outlets **192** in the process chamber **108**. A gas flow valve 196 regulates the flow of the process gas through the gas feed conduit **184**, and therefore through the gas outlets **192**. From the gas outlets **192**, the process gas is released into the process zone **112**. For example, a gas outlet **192** may be located peripherally around the substrate **104** (as shown in Figure 4).

In one version, the substrate **104** is etched in a process gas comprising an etchant gas that reacts with the substrate **104,** for example that reacts with a metal-containing material on the substrate **104**, to form volatile gaseous compounds. The etchant gas comprises a composition containing halogen-containing gases that when energized react with and etch the metal-containing material. For etching aluminum or aluminum alloys and compounds, suitable halogen-containing etchant gases may comprise one or more chlorine-containing gases, such as for example, HCl, BCl₃, Cl₂, and mixtures thereof. For etching tungsten or tungsten alloys and compounds, fluorine-containing gases, such as SF₆, NF₃ or F₂, and mixtures thereof, may be used. Alloys or compounds that contain copper or titanium can be etched with fluorine or chlorine-containing gases. Although the invention is illustrated by particular compositions of halogen gases, it should be understood that the present invention should not be limited to the halogen gases described herein.

A gas energizer **200** energizes the process gas introduced into the chamber **108** to form a plasma to process the substrate **104**. The gas energizer **200** couples electromagnetic power, such as RF (radio frequency) power, into the process gas. A suitable gas energizer **200** comprises an inductor antenna **204** having one or more inductor coils **208** above the ceiling **176** of the chamber **108**. The ceiling **176** may comprise a dielectric material that is permeable to the electromagnetic energy, such as silicon or silicon dioxide. An antenna power supply **212** applies AC power, such as RF power, to the antenna via a match network **216** that tunes the applied power to optimize the inductive coupling of the power to the process gas.

The process gas in the chamber **108** is exhausted by a gas exhaust **220** that includes an exhaust conduit **224**, an exhaust line **228**, a throttle valve **232**, and pumps **236** that can include roughing and turbo-molecular pumps. The pumps **236** may further comprise scrubber systems to clean the exhaust gas. The exhaust conduit **224** is a port or channel that receives the exhaust gas provided in the chamber **108**, and that is typically positioned around the periphery of the substrate **104**. The exhaust line **228** connects the exhaust conduit **224** to the pumps **236**, and the throttle valve **232** in the exhaust line **228** may be used to control the pressure of the process gas in the chamber **108**.

The substrate processing in the chamber **108** may be implemented using a controller **240**. The controller **240** comprises a central processing unit (CPU) interconnected with a memory and peripheral control components. The CPU may comprise, for example, a 68040 microprocessor, fabricated by Synergy Microsystems Inc., San Diego, California. The controller **240** comprises a computer program product, which comprises program code embodied on a computer-readable medium, such as the memory of the controller **240**. The program code can be written in any conventional computer-readable programming language, such as for example, assembly language or C++. Suitable program code is entered into a single file, or multiple files, using a conventional text editor, and stored or embodied in the computer-readable medium. If the entered code text is in a high level language, the code is compiled, and the resultant compiler code is then linked with an object code of precompiled library routines. To execute the linked compiled object code, the operator invokes the program code, causing the controller **240** to load the object code into the computer-readable medium. The CPU reads and executes the program code to perform the tasks identified therein.

Although exemplary embodiments of the present invention are shown and described, those of ordinary skill in the art may devise other embodiments that incorporate the present invention, and which are also within the scope of the present invention. For example, the electrostatic chuck **120** described herein can be used in a deposition chamber or another chamber. Also, the electrostatic chuck **120** may comprise materials other than those specifically mentioned, as would be apparent to one of ordinary skill in the art. Furthermore, the terms below, above, bottom, top, up, down, first, and second, and other relative or positional terms are shown with respect to the exemplary embodiments in the Figures and are interchangeable insofar as objects can be rotated or translated in space. Therefore, the appended claims should not be limited to the descriptions of the preferred versions, materials, or spatial arrangements described herein to illustrate the invention.

## Claims

1. An electrostatic chuck to hold a substrate in a process chamber, the electrostatic chuck comprising:
(a) an electrode comprising a central planar portion comprising a top surface, bottom surface, and perimeter, and either of:
(i) a wire loop that extends substantially continuously about the perimeter of the electrode and has a radially outwardly facing surface that is substantially rounded; or
(ii) a peripheral arcuate portion having a tip with an upper surface, the arcuate portion having curvature length of at least about Π/8 radians between a normal to the top surface of the central planar portion and a normal to the upper surface of the tip; and
(b) a dielectric covering the electrode.

2. An electrostatic chuck according to claim 1 wherein the wire loop has a substantially circular cross-section.

3. An electrostatic chuck according to claim 2 wherein the substantially circular cross-section has a diameter that is larger than the cross-sectional thickness of the electrode.

4. An electrostatic chuck according to any one of the preceeding claims wherein the wire loop or peripheral arcuate portion has a curvature diameter of at least about 3 micrometers.

5. An electrostatic chuck according to any one of the preceeding claims further comprising a sidewall edge and wherein the current leakage through the sidewall edge is less than about 100 µA.

6. An electrostatic chuck according to any one of the preceeding claims wherein the tip of the peripheral arcuate portion extends substantially entirely beyond the bottom surface of the central planar portion.

7. An electrostatic chuck according to any one of the preceeding claims wherein the electrode comprises a wire mesh.

8. A substrate processing apparatus for processing a substrate, the substrate processing apparatus comprising:
(1) a process chamber comprising the electrostatic chuck according to any one of the preceeding claims to hold a substrate in the process chamber.
(2) a gas distributor to introduce a process gas into the process chamber;
(3) a gas energizer to energize the process gas in the process chamber to process the substrate; and
(4) a gas exhaust to exhaust the process gas from the process chamber.
